# DEMANDE DE BREVET EUROPEEN

(11) **EP 1 783 872 A1**
(43) Date de publication de la demande: **09.05.2007**
(21) Numéro de dépôt: 06122961.3
(22) Date de dépôt: 25.10.2006
(51) Int. Cl.: H01S 3/067, G02B 6/036

(54) **Fibre optique amplificatrice**

(30) Priorité: 08.11.2005 FR 0553374
(71) Demandeur: Alcatel Lucent, 75008 Paris (FR)
(72) Inventeur: Simonneau, Christian, 92160, ANTONY (FR); Blanchandin, Stéphanie, 75015, PARIS (FR); Gasca, Laurent, 91140, VILLEBON-SUR-YVETTE (FR); Bayart, Dominique, 92140, CLAMART (FR)
(74) Mandataire: Sciaux, Edmond

(57) **Abrégé**

L'invention a pour objet une fibre optique amplificatrice comprenant un coeur (22) contenant un dopant (30) et une gaine (28), dans laquelle ledit coeur comprend un coeur monomode (24) destiné à propager un signal optique, des nanoparticules (32) d'un matériau semiconducteur étant disposées dans ou à proximité dudit coeur monomode (22), et un coeur multimode (26), entourant le coeur monomode (24), destiné à recevoir un signal de pompage.

## Description

La présente invention concerne le domaine des fibres optiques amplificatrices et des amplificateurs à fibre optique.

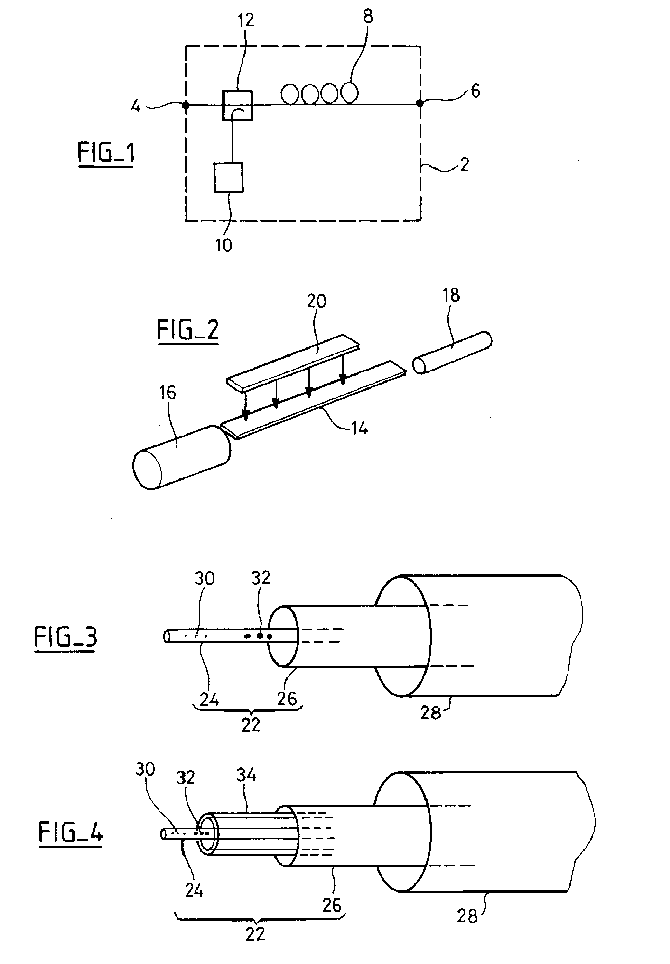

On a représenté schématiquement sur la figure 1 un amplificateur à fibre optique. Cet amplificateur 2 comprend un port d'entrée 4 et un port de sortie 6 destinés à être raccordés à une fibre de ligne. L'amplificateur se compose d'une fibre optique dopée 8, d'une source de pompage 10 et d'un coupleur optique 12. La source de pompage est en général un laser et délivre un signal optique de pompage qui est injecté dans la fibre dopée 8 par le coupleur optique 12. Ce signal optique de pompage est absorbé par le dopant, choisi parmi les terres rares et notamment l'erbium, présent dans le coeur de la fibre optique dopée qui, en se désexcitant, transfère une partie de l'énergie absorbée au signal optique se propageant entre les ports 4 et 6 et amplifiant ainsi ce signal optique.

La fibre optique dopée peut comprendre un coeur monomode dans lequel se trouve le dopant et dans lequel le signal optique de pompage est injecté. Elle peut comprendre aussi un coeur monomode recevant le dopant et un coeur multimode, entourant le coeur monomode, pour recevoir le signal de pompage. Ce deuxième mode de réalisation présente l'avantage de permettre d'injecter un signal de pompage plus puissant et de réaliser un meilleur couplage entre le signal optique de pompage et le dopant.

Par ailleurs, on sait qu'il est possible de choisir la longueur d'onde du signal de pompage par l'utilisation de nanoparticules, et particulièrement par le choix du type de nanoparticule et de la taille des nanoparticules, comme indiqué par exemple dans l'article « highly luminescent silicon nanocrystal with discrete optical transitions» J. D. Holmes et al., J.Am. Chem. Soc. 123 (2001) pp3743-3748.

Cependant, les nanoparticules ont une section d'absorption extrêmement élevée. Ainsi, dans le cas d'une fibre optique monomode, le signal de pompage est absorbé par les nanoparticules sur une longueur de fibre de l'ordre de 50 µm. Il n'est pas possible avec la technologie actuelle d'insérer une concentration suffisante de dopant sur une si courte distance, de sorte qu'il n'est pas possible de transférer l'énergie absorbée par les nanoparticules au dopant de manière efficace.

Pour contourner cette difficulté, il a été proposé dans l'article « Optical gain at 1.5 µm in nanocrystal Si sensitized, Er-doped silica waveguide using top-doping 470 nm LED », J. Lee et al, OFC'04, PD19 un dispositif tel que représenté sur la figure 2. Ce dispositif comporte un guide d'onde plat 14, comportant des nanoparticules de Si et un dopant Er, placé entre deux éléments 16 et 18 de fibre de ligne, et une barrette de photodiodes 20. La barrette 20 délivre un signal de pompage 22 transversalement au guide d'onde plat, de manière à ce que ce signal de pompage soit injectée sur une longueur suffisante du guide d'onde plat. La longueur du guide d'onde plat est de 11 mm dans l'exemple décrit.

Cette solution n'est cependant pas encore satisfaisante. En effet, on conçoit que la longueur du guide d'onde ne puisse être très importante (elle est du même ordre de grandeur que la longueur de la barrette de photodiodes), de sorte qu'il reste nécessaire de doper fortement le guide d'onde. Ceci provoque des effets coopératifs entre les ions du dopant, ce qui diminue fortement l'efficacité de la conversion optique et donc l'amplification du signal optique à amplifier.

Par ailleurs, une perte de couplage ne peut être évitée entre un guide d'onde plat et une fibre de ligne circulaire.

L'invention a pour but de pallier les inconvénients de l'art antérieur dans le cas d'une fibre optique amplificatrice comprenant des nanoparticules.

Plus précisément, l'invention a pour objet une fibre optique amplificatrice comprenant un coeur contenant un dopant et une gaine, dans laquelle ledit coeur comprend un coeur monomode destiné à propager un signal optique, des nanoparticules d'un matériau semiconducteur étant disposées dans ou à proximité dudit coeur monomode, et un coeur multimode, entourant le coeur monomode, destiné à recevoir un signal de pompage.

De manière avantageuse, lesdites nanoparticules de matériau semiconducteur et/ou ledit dopant sont disposés dans le coeur monomode.

Selon un mode préféré de réalisation, lesdites nanoparticules de matériau semiconducteur et/ou ledit dopant sont disposés dans un anneau entourant le coeur monomode.

Le matériau semiconducteur comprend, de manière préférée, au moins l'un des matériaux parmi Si, Ge, PbTe, PbS.

L'invention a également pour objet un amplificateur à fibre optique comprenant une fibre amplificatrice selon l'invention, une source de pompage optique et un moyen d'injection du signal optique de pompage dans le coeur multimode de la fibre optique amplificatrice.

Les particularités et avantages de l'invention ressortiront plus clairement à la lecture de la description qui suit, faite à titre d'exemple illustratif et non limitatif, en référence aux figures annexées dans lesquelles :
la figure 1, déjà décrite, illustre schématiquement la structure d'un amplificateur à fibre optique,
la figure 2, déjà décrite, illustre un amplificateur à fibre optique selon l'art antérieur comportant un guide d'onde dopé et contenant des nanoparticules,
la figure 3 illustre un premier mode de réalisation d'une fibre optique amplificatrice selon l'invention, et
la figure 4 illustre un deuxième mode de réalisation d'une fibre optique amplificatrice selon l'invention.

On a représenté en perspective sur la figure 3 une fibre optique amplificatrice selon un premier mode de réalisation de l'invention. Cette fibre optique comprend un coeur 22, formé d'un coeur monomode 24 entouré d'un coeur multimode 26, et une gaine 28.

Le coeur monomode 24 comprend un dopant 30 permettant l'amplification d'un signal optique se propageant dans ce coeur monomode. Le dopant peut être de tout type connu, et notamment une terre rare, et en particulier l'erbium. Il comprend également des nanoparticules 32 d'un matériau semiconducteur.

Le coeur multimode 26 est destiné à recevoir un signal optique de pompage. Ainsi, contrairement à l'art antérieur représenté sur la figure 2, l'invention permet au signal de pompage de se propager sur une distance importante avant d'être absorbé par les nanoparticules 32. L'absorption du signal de pompage dans le coeur multimode est d'autant réduite que le diamètre du coeur multimode est important. Le fait de disposer d'une plus grande longueur pour l'absorption du signal optique de pompage permet de répartir le dopant sur une distance plus importante et donc d'en réduire la concentration.

Selon un exemple de réalisation avantageux de l'invention, les nanoparticules de semiconducteur sont formées de silicium et le dopant est un ion de terre rare, par exemple de l'erbium). Le coeur monomode a un diamètre de 4 µm alors que le coeur multimode a un diamètre de 400µm. La longueur d'onde de pompage est choisie de telle sorte que la section efficace des nanoparticules de semiconducteur à la longueur d'onde de pompe soit inférieure ou égale à 100 fois la section efficace d'absorption des ions de terre rare. Cette longueur d'onde dépend donc de la taille et de la nature de la nanoparticule de semiconducteur. Une taille avantageuse de nanoparticules de silicium se situe aux alentours de 3nm de diamètre (non compris la couche d'oxide). Cette taille permet d'exalter le transfert d'énergie entre la nanoparticule et l'ion de terre rare tout en minimisant les pertes par diffusion de ces nanoparticules. Cependant la taille des nanoparticules peut avantageusement se situer dans la gamme 2nm-5nm. Dans le cas de nanoparticules de silicium de 3 nm de diamètre, la longueur d'onde de pompe peut se situer avantageusement entre 400nm et 500nm. Dans ce mode de réalisation il est préférable que la concentration en ions erbium ne dépasse pas 7.10¹⁸ ions/cm³ de façon à limiter les effets coopératifs ente ions et garder un bon rendement de conversion. Dans ce cas, la longueur typique d'une fibre serait de 7m pour obtenir un gain de 21 dB.

Les nanoparticules sont choisies en fonction de l'application visée. En particulier le matériau utilisé et la taille des nanoparticules sont choisies en fonction de la longueur d'onde du signal de pompage sélectionnée.

A titre d'exemple, le matériau semiconducteur des nanoparticules est choisi parmi au moins l'un des matériaux suivants : Si, Ge, PbTe, PbS.

On a représenté sur la figure 4 une fibre optique amplificatrice selon un deuxième mode de réalisation de l'invention. Les éléments identiques à ceux de la figure 3 portent des références numériques identiques.

Le mode de réalisation de la figure 4 diffère de celui de la figure 3 en ce que les particules 30 de dopant et les nanoparticules 32 en matériau semiconducteur sont disposés dans un anneau 34 entourant le coeur monomode 24.

Ce mode de réalisation permet de réduire la taille du coeur multimode. Ainsi si la position et la taille de l'anneau sont telles que l'intégrale de recouvrement entre le signal monomode et la zone dopée est réduite d'un facteur 3.33 par rapport à un dopage dans le coeur, les pertes par diffusions seront réduites d'un facteur 3.33. De plus, le diamètre du coeur multimode peut être réduit d'un facteur 10 par rapport au cas précédant. Dans ce mode de réalisation, le diamètre du coeur multimode est donc de 40µm et la longueur de la fibre de l'ordre de 70m.

Cette disposition permet aussi de réduire les pertes dues à la diffusion engendrée par les nanoparticules. En effet, l'indice de réfraction des nanoparticules est généralement beaucoup plus élevé que celui du matériau de la fibre optique (en général, la silice) ce qui provoque une diffusion Mie croissant avec la taille des nanoparticules. La diffusion de Mie désigne la diffusion par des particules dont le rayon oscille entre 0.1 et 10 fois la longueur d'onde. On note que la puissance diffusée est maximale lorsque la longueur d'onde est proche du rayon de la particule. Contrairement à la théorie de Rayleigh, la puissance rétro-diffusée est plus grande que la puissance diffusée dans la direction de l'onde incidente. Dans le cas où les nanoparticules sont dans un anneau entourant le coeur monomode, seul le bord du champ interagit avec les nanoparticules, ce qui réduit les pertes. En effet, plus l'intégrale de recouvrement entre le champ et la source de diffusion (ici les nanoparticules) est faible plus les pertes par diffusion sont faibles.

La fibre amplificatrice selon l'invention est destinée à être associée à une source de pompage, telle que 10, et à un moyen d'injection, tel que 12, du signal de pompage dans le coeur multimode pour former un amplificateur à fibre optique ayant une structure telle que représentée sur la figure 1.

## Revendications

1. Fibre optique amplificatrice comprenant un coeur (22) contenant un dopant (30) et une gaine (28), **caractérisée en ce que** ledit coeur comprend
- un coeur monomode (24) destiné à propager un signal optique, des nanoparticules (32) d'un matériau semiconducteur étant disposées dans ou à proximité dudit coeur monomode (24), et
- un coeur multimode (26), entourant le coeur monomode (24), destiné à recevoir un signal de pompage.

2. Fibre optique selon la revendication 1, **caractérisée en ce que** lesdites nanoparticules (32) de matériau semiconducteur sont disposées dans le coeur monomode (24).

3. Fibre optique selon la revendication 1 ou 2, **caractérisée en ce que** ledit dopant (30) est disposé dans le coeur monomode (24).

4. Fibre optique selon la revendication 1, **caractérisée en ce que** lesdites nanoparticules (32) de matériau semiconducteur sont disposées dans un anneau (34) entourant le coeur monomode (24).

5. Fibre optique amplificatrice selon l'une des revendications 1 ou 4,
**caractérisée en ce que** ledit dopant (30) est disposé dans un anneau (34) ) entourant le coeur monomode (24).

6. Fibre optique amplificatrice selon l'une des revendications 1 à 5, **caractérisé en ce que** le matériau semiconducteur comprend au moins l'un des matériaux parmi Si, Ge, PbTe, PbS.

7. Fibre optique amplificatrice selon l'une des revendications 1 à 6, **caractérisée en ce que** le dopant est une terre rare.

8. Amplificateur à fibre optique comprenant
- une fibre amplificatrice comprenant un coeur (22) contenant un dopant (30) et une gaine (28), dans laquelle ledit coeur (22) comprend un coeur monomode (24) destiné à propager un signal optique, des nonoparticules (32) d'un matériau semiconducteur étant disposées dans ou à proximité dudit coeur monomode (24), et un coeur multimode (26), entourant le coeur monomode (24), destiné à recevoir un signal de pompage,
- une source de pompage optique (10),et
- un moyen d'injection (12) du signal optique de pompage dans le coeur multimode (24) de la fibre optique amplificatrice.
